# EUROPÄISCHE PATENTANMELDUNG

(11) **EP 1 189 112 A2**
(43) Veröffentlichungstag der Anmeldung: **20.03.2002**
(21) Anmeldenummer: 01116994.3
(22) Anmeldetag: 12.07.2001
(51) Int. Cl.: G03F 7/20

(54) **Projektionsbelichtungsanlage**

(30) Priorität: 19.09.2000 DE 10046218
(71) Anmelder: Carl Zeiss, 89518 Heidenheim (Brenz) (DE)
(72) Erfinder: Drodofsky, Ulrich, 9442 Berneck (CH); Dieckmann, Nils, 73434 Aalen (DE); Miesner, Hans-Joachim, 73447 Oberkochen (DE); Antoni, Martin, 73434 Aalen (DE)
(74) Vertreter: Ostertag, Ulrich, Dr.

(57) **Zusammenfassung**

Eine Projektionsbelichtungsanlage (1), insbesondere für die Mikrolithographie, dient zur Erzeugung eines Bildes eines in einer Objektebene (10) angeordneten Objekts (2) in einer Bildebene (11). Dazu weist die Projektionsbelichtungsanlage (1) eine Projektionsstrahlung (5) emittierende Strahlungsquelle (4) auf. Zwischen der Strahlungsquelle (4) und der Objektebene (10) ist eine Beleuchtungsoptik (6) und zwischen der Objektebene (10) und der Bildebene (11) ist eine Projektionsoptik (8) angeordnet. Zur Messung der Beleuchtungswinkelverteilung der Projektionsstrahlung (5) in einer Feldebene (10) ist eine Detektionseinrichtung (30) vorgesehen. Diese steht über mindestens eine Steuereinrichtung (34, 18) mit mindestens einem Manipulator (20, 45, 47) in Verbindung. Letzterer dient zur Bewegung von mindestens einer optischen Komponente (7, 41) innerhalb des Projektionsstrahlengangs (5, 9). Durch die gesteuerte Bewegung der optischen Komponente (7, 41) erfolgt eine Änderung der Beleuchtungswinkelverteilung. Diese ist somit in Abhängigkeit vom Messergebnis einstellbar und z.B. an die Objektstruktur anpaßbar.

## Beschreibung

Die Erfindung betrifft eine Projektionsbelichtungsanlage, insbesondere für die Mikrolithographie, zur Erzeugung eines Bildes eines in einer Objektebene angeordneten Objekts in einer Bildebene mit einer Projektionsstrahlung emittierenden Strahlungsquelle, mit einer im Strahlengang zwischen der Strahlungsquelle und der Objektebene angeordneten Beleuchtungsoptik und einer im Strahlengang zwischen der Objektebene und der Bildebene angeordneten Projektionsoptik.

Wo dreidimensionale Strukturen projiziert werden sollen, also z. B. bei der Übertragung von dreidimensionalen Strukturen von einem Retikel auf einen Wafer im Rahmen der Mikro-Lithographie, hat sich herausgestellt, daß es nicht nur auf eine möglichst homogene Beleuchtung der Objektebene sondern auch auf eine wohldefinierte Verteilung der Beleuchtungswinkel in der Objektebene, d. h. der Winkel, unter denen die Projektionsstrahlung auf die Objektebene auftrifft, ankommt. Die einzustellende Beleuchtungswinkelverteilung hängt davon ab, wie die Strukturen auf dem Retikel angeordnet sind und welche Ausdehnung sie senkrecht zur Objektebene aufweisen. Für unterschiedliche Retikel-Strukturen können sich daher unterschiedliche vorzugebende Beleuchtungswinkelverteilungen zur optimalen Projektion ergeben.

Bei vom Markt her bekannten Projektionsbelichtungsanlagen erfolgt eine Messung der Beleuchtungsintensität durch einen Photosensor, der beispielsweise die Reflexion einer optischen Komponente der Projektionsbelichtungsanlage aufnimmt.

Die Messung einer Beleuchtungswinkelverteilung ist mit einem derartigen Photosensor nicht möglich.

Es ist daher die Aufgabe der vorliegenden Erfindung, eine Projektionsbelichtungsanlage der eingangs genannten Art derart weiterzubilden, daß die Beleuchtungswinkelverteilung ermittelbar ist und an die gewünschte Verteilung herangeführt werden kann.

Diese Aufgabe wird erfindungsgemäß dadurch gelöst, daß:
a) eine Detektionseinrichtung vorgesehen ist, welche die Beleuchtungswinkelverteilung der Projektionsstrahlung in einer Feldebene mißt;
b) die Detektionseinrichtung über mindestens eine Steuereinrichtung mit mindestens einem Manipulator zur Bewegung von mindestens einer optischen Komponente innerhalb des Strahlengangs der Projektionsstrahlung in Verbindung steht; und
c) mindestens eine der optischen Komponenten derart ausgeführt und im Strahlengang der Projektionsstrahlung angeordnet ist, daß durch ihre gesteuerte Bewegung eine Änderung der Beleuchtungswinkelverteilung erfolgt.

Als Projektionsstrahlung kann hierbei z.B. Projektionslicht optischer Wellenlängen, UV-Projektionslicht oder auch EUV-Projektionsstrahlung, z.B. Strahlung mit einer Wellenlänge von 13nm, eingesetzt sein.

Mit der Detektionseinrichtung wird ein Ist-Zustand der Beleuchtungswinkelverteilung gemessen. Die Messung der Beleuchtungswinkelverteilung ermöglicht gleichzeitig den Zugang zu einer Reihe von weiteren Informationen, die bei der Projektion von Interesse sind. Beispielsweise erlaubt sie auf einfache Weise die Ermittlung der Telezentriewinkelverteilung in der vermessenen Feldebene. Ferner sind mit der gemessenen Beleuchtungswinkelverteilung auch die Verteilung der numerischen Apertur des Beleuchtungslichts sowie die Beleuchtungsintensitätsverteilung über die vermessene Feldebene bekannt.

Die Feldebene, deren Beleuchtungswinkelverteilung vermessen wird, kann dabei die Objektebene selbst oder eine zu dieser konjugierte Ebene sein.

Mit Hilfe der Steuereinrichtung und dem mindestens einen zugeordneten Manipulator ist über die Bewegung der mindestens einen optischen Komponente eine Anpassung der gemessenen Beleuchtungswinkelverteilung an einen Vorgabewert möglich. Dabei können für eine Komponente ein Manipulator oder mehrere Manipulatoren vorgesehen sein. Mit Hilfe dieser Anpassung ist z.B. abhängig von der zu projizierenden Struktur eine optimierte Beleuchtung des Objekts möglich.

Die Detektionseinrichtung kann aufweisen: eine Lochblende, die in einer Feldebene anordenbar ist, einen positionsauflösenden Sensor zur Erfassung der durch die Lochblende tretenden Strahlung und eine Antriebseinrichtung zur Bewegung der Lochblende zusammen mit dem Sensor in der Feldebene. Mit dieser relativ einfachen Ausgestaltung ist eine präzise Vermessung der Beleuchtungswinkelverteilung in der Feldebene möglich. Der Durchmesser der Lochblende gibt dabei die Ortsauflösung in der Feldebene vor. Mittels der Antriebseinrichtung wird die Detektionseinrichtung über die gesamte zu vermessende Feldebene verfahren. Mit einer derartigen Detektionseinrichtung läßt sich zusätzlich die Beleuchtungsintensitätsverteilung in der Feldebene messen.

Der positionsauflösende Sensor kann ein CCD-Array sein. Ein CCD-Array ist lichtempfindlich und weist eine hohe Positionsauflösung auf. Mit Hilfe bekannter Beschichtungen kann die Sensitivität des CCD-Arrays bis in den für die Mikro-Lithographie interessanten Beleuchtungswellenlängenbereich der UV-Wellenlängen ausgedehnt werden. Wenn nur eine geringe Positionsauflösung für den positionsauflösenden Sensor gefordert ist, kann dieser auch z.B. als einfacher Quadrantendetektor ausgeführt sein.

Im Strahlengang zwischen der Lochblende und dem positionsauflösenden Sensor kann mindestens ein optisches Umlenkelement angeordnet sein. Dies verringert die Bautiefe der Detektionseinrichtung in Richtung der optischen Achse. Gerade bei Projektionsbelichtungsanlagen mit hoher baulicher Integration ist der Raum, in dem die Detektionseinrichtung angeordnet werden kann, sehr begrenzt.

Im Strahlengang zwischen der Lochblende und dem positionsauflösenden Sensor kann mindestens ein Filter angeordnet sein. Das Filter kann einen Spektralfilter umfassen, so daß z.B. nur die interessierende Beleuchtungswellenlänge durchgelassen wird. Ein Beispiel für ein derartiges Filter ist ein Notchfilter. Andere Wellenlängen, die die Messung unter Umständen stören könnten, werden unterdrückt. Alternativ oder zusätzlich kann das Filter ein Graufilter oder ein Reflexionsfilter zur neutralen Schwächung eines größeren Wellenlängenbereichs aufweisen.

Im Strahlengang zwischen der Lochblende und dem positionsauflösenden Sensor kann mindestens eine Linse angeordnet sein. Eine derartige Linse kann z.B. die Auflösung der Detektionseinrichtung erhöhen.

Eine mit dem Manipulator zusammenarbeitende optische Komponente kann ein Filter sein. Mit einem Filter ist eine gezielte bereichsweise Schwächung des Projektionslichtbündels möglich. Das Filter kann als Absorptionsoder als Reflexionsfilter aufgebaut sein. Statt eines Filters mit einer beweglichen Filterkomponente, bei dem durch Bewegung der beweglichen Filterkomponente die Transmission in der Filterebene verändert wird, kann auch ein Wechselhalter für eine Mehrzahl austauschbarer Filter vorgesehen sein.

Das Filter kann im Bereich einer Feldebene der Projektionsoptik angeordnet sein. Ist das Filter in oder nahe einer Feldebene angeordnet, beeinflußt es praktisch ausschließlich die Beleuchtungsintensitätsverteilung in der Objektebene, nicht aber die dortige Beleuchtungswinkelverteilung.

Alternativ kann das Filter im Bereich einer Pupillenebene der Projektionsoptik angeordnet sein. Ein derartiges in oder nahe einer Pupillenebene der Projektionsoptik angeordnetes Filter beeinflußt die Beleuchtungsintensität in dieser Ebene und dient dadurch zur Vorgabe der Beleuchtungswinkelverteilung in der Objektebene, während die Beleuchtungsintensitätsverteilung in der Objektebene nicht oder kaum beeinflußt wird. Über die Verlagerung des Filters bzw. der beweglichen Filterkomponente mit Hilfe des Manipulators wird entsprechend die Beleuchtungswinkelverteilung geändert.

Als Manipulator kann mindestens ein Z-Manipulator für eine optische Komponente der Projektionsoptik vorgesehen sein. Die Z-Richtung ist dabei die Richtung, in der die optische Achse der Projektionsoptik verläuft. Auch mittels der Z-Manipulation optischer Komponenten ist eine Änderung der Beleuchtungswinkelverteilung möglich.

Eine derartige optische Komponente kann eine Linse sein. Mit Hilfe einer Z-manipulierbaren Linse kann neben der Beleuchtungswinkelverteilung noch zusätzlich ein Abbildungsfehler der Projektionsbelichtungsanlage korrigiert werden.

Eine andere derartige Z-manipulierte optische Komponente kann ein Axicon sein. Mit Hilfe eines Axicons kann auf einfache Weise eine gesteuert veränderbare rotationssymmetrische Beleuchtungswinkelverteilung eingestellt werden.

Eine manipulierbare optische Komponente kann eine Justageeinrichtung der Strahlungsquelle sein. Mit Hilfe der Justageeinrichtung, kann beispielweise die Divergenz des von der Strahlungsquelle ausgestrahlten Projektionsstrahlungsbündels eingestellt werden. Dies ist ein zusätzlicher Einflußparameter für die Beleuchtungswinkelverteilung.

Der Manipulator kann ein Piezoelement aufweisen. Mit Piezoelementen läßt sich eine reproduzierbare und präsize Verlagerung erzielen. Werden mehrere Piezoelemente zur Manipulation einer optischen Komponente eingesetzt, läßt sich neben der Z-Position auch die Neigung der optischen Komponente gegen die optische Achse einstellen.

Neben den vorstehend angesprochenen manipulierbaren optischen Komponenten sind zur Beeinflußung der Beleuchtungswinkelverteilung noch andere denkbar. Beispiele für diese sind gegeneinander verlagerbare Keilplatten, kippbare oder Z-manipulierbare planparallele optische Platten, Aperturblenden mit veränderbarer Öffnung oder, bei katadioptrischen Projektionsobjektiven, aktive Spiegel.

Ausführungsbeispiele der Erfindung werden nachfolgend anhand der Zeichnung näher erläutert; es zeigen:
- Figur 1: eine schematische Übersicht einer Projektionsbelichtungsanlage;
- Figuren 2 und 3: zwei Ausführungsbeispiele einer Detektionseinrichtung für eine Beleuchtungswinkelverteilung und eine Beleuchtungsintensitätsverteilung in einer Objektebene der Projektionsbelichtungsanlage.

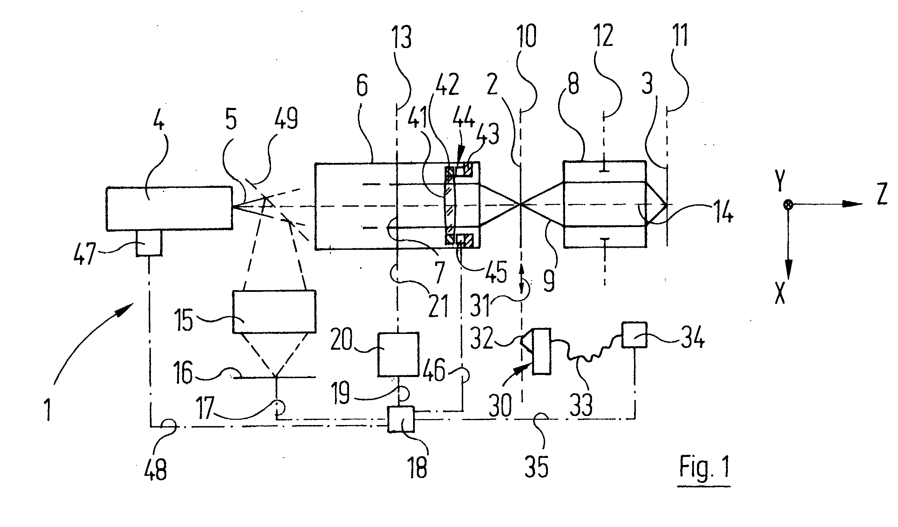

In Figur 1 ist schematisch eine insgesamt mit dem Bezugszeichen 1 versehene Projektionsbelichtungsanlage für die Mikrolithographie dargestellt. Mit dieser wird eine Struktur auf einem Retikel 2 auf die Oberfläche eines Wafers 3 übertragen.

Als Strahlungsquelle für die Projektionsbelichtungsanlage 1 dient ein UV-Laser 4, z.B. ein ArF-Excimerlaser mit einer Wellenlänge von 193,3 nm.

Mit dem UV-Laser 4 gekoppelt ist eine gesteuerte Justageeinrichtung 47. Hierbei handelt es sich z.B. um eine oder mehrere mit einem Aktuator gekoppelte Mikrometerschrauben. Die Justageeinrichtung 47 ist an einer optischen Komponente des UV-Laser 4 angeordnet und über eine Steuerleitung 48 mit einer Steuereinrichtung 18 verbunden.

Ein von dem UV-Laser 4 emittiertes Projektionslichtbündel 5 tritt zunächst in eine Beleuchtungsoptik 6 ein. Der Strahlengang des Projektionslichtbündels 5 ist der Übersichtlichkeit wegen nur zwischen dem UV-Laser 4 und der Beleuchtungsoptik 6 angedeutet. Die Beleuchtungsoptik 6 ist in Figur 1 größtenteils schematisch als Block dargestellt und kann neben Linsen und ggf. auch Spiegeln eine Reihe weiterer optischer Elemente bzw. Baugruppen, z. B. ein Zoom-Objektiv, ein Axicon, eine verschiebbare Keilplatte, diffraktive optische Elemente, ein Filter und einen Glasstab zur Vorgabe einer Beleuchtungsintensitätsverteilung und einer Beleuchtungswinkelverteilung des Projektionslichtbündels 5 aufweisen. Alle diese optischen Komponenten können gesteuert verlagerbar sein.

Stellvertretend für ein optisches Element innerhalb der Beleuchtungsoptik 6 ist eine Linse 41 dargestellt, die in einer sie umfassenden Linsenfassung 42 angeordnet ist. In nicht dargestellter Weise ist die Linsenfassung 42 gegen einen Haltering 43 vorgespannt. Letzterer ist an seiner äußeren Umfangsfläche fest mit einem Gehäuse der Beleuchtungsoptik 6 verbunden.

In zur Beleuchtungsoptik 6 axialer Richtung ist zwischen der Linsenfassung 42 und dem Haltering 43 eine Gruppe von Piezoaktuatoren 44 angeordnet. Diese umfaßt mehrere einzelne Piezoaktuatoren 45, von denen in Figur 1 zwei dargestellt sind. Über eine mehrpolige, strichpunktiert dargestellte Steuerleitung 46 stehen die Piezoaktuatoren 45 mit der Steuereinrichtung 18 in Verbindung.

Beim Durchtritt durch die Beleuchtungsoptik 6 passiert das Projektionslichtbündel 5 ein in einer Pupillenebene 13 angeordnetes Pupillenfilter 7, welches in der Beleuchtungsoptik 6 ebenfalls stellvertretend für dort angeordnete optische Komponenten dargestellt ist. Die Pupillenebene 13 wird nachfolgend auch Filterebene genannt.

Das die Beleuchtungsoptik 6 verlassende Projektionslichtbündel 5 beleuchtet das Retikel 2. Die Strukturen des Retikels 2 werden mit Hilfe einer Projektionsoptik 8 auf die Oberfläche des Wafers 3 projiziert. Die Projektionsoptik 8 kann aus einer Mehrzahl von Linsen und/oder Spiegeln aufgebaut sein.

Ein ausgewähltes, einen zentralen Objektpunkt auf dem Retikel 2 passierendes und mit der Projektionsoptik 8 geführtes Abbildungslichtbündel ist in Figur 1 mit dem Bezugszeichen 9 versehen und zur Verdeutlichung des Abbildungsstrahlengangs ein Stück weit in Gegenrichtung, also in Richtung auf die und in die Beleuchtungsoptik 6 verlängert. Das Retikel 2 liegt in der Objektebene 10 der Projektionsoptik 8, die in Figur 1 durch eine gestrichelte Linie angedeutet ist. Die Objektebene 10 fällt mit einer Kollimationsebene des Projektionslichtbündels 5 zusammen. Der Wafer 3 liegt in einer ebenfalls durch eine gestrichelte Linie angedeuteten Bildebene 11 der Projektionsoptik 8. Eine Pupillenebene 12 der Projektionsoptik 8 ist in Figur 1 ebenfalls schematisch angedeutet. Sie ist zur Filterebene 13 in der Beleuchtungsoptik 6 konjugiert.

Die optische Achse der Projektionsbelichtungsanlage ist in Figur 1 ebenfalls gestrichelt angedeutet und mit dem Bezugszeichen 14 versehen. Sie verläuft in Z-Richtung des in Fig. 1 rechts dargestellten kartesischen Koordinatensystems X, Y und Z.

Im Strahlengang zwischen dem UV-Laser 4 und der Beleuchtungsoptik 6 ist eine teildurchlässige optische Platte 49 angeordnet, die einen geringen Anteil des Projektionslichtbündels 5 reflektiert und den überwiegenden Anteil, in der Praxis mehr als 99%, des Projektionslichtbündels 5 transmittiert. Der Strahlengang des die optische Platte 49 durchtretenden Projektionslichtbündels 5 ist, da er hier nicht weiter interessiert, nur noch ein Stück weit gestrichelt fortgesetzt.

Der reflektierte, ebenfalls gestrichelt dargestellte Anteil des Projektionslichtbündels 5 nach der optischen Platte 49 wird mittels einer Abbildungsoptik 15 auf ein zweidimensionales CCD-Array 16 abgebildet. Mit diesem kann somit die Intensitätsverteilung des Projektionslichtbündels 5 aufgenommen werden.

Das CCD-Array 16 steht über eine strichpunktiert dargestellte Signalleitung 17 mit der Steuereinrichtung 18 in Verbindung.

Eine alternativ oder zusätzlich zum CCD-Array 16 einsetzbare Detektionseinrichtung 30 zur Messung der Beleuchtungsintensitäts- und der Beleuchtungswinkelverteilung des Abbildungsbündels 9 in der Objektebene 10 ist in Figur 1 in einer inaktiven Stellung außerhalb des Projektionsstrahlengangs dargestellt. Mittels einer nicht dargestellten Antriebseinrichtung kann die Detektionseinrichtung 30 in der X,Y-Ebene senkrecht zur optischen Achse 14, wie durch den Doppelpfeil 31 dargestellt, nach Entfernen des Retikels 2 derart in den Strahlengang eingeschoben werden, daß eine als Lochblende ausgeführte Eintrittsöffnung 32 in der Objektebene 10 liegt. Durch diese kann ein normalerweise das Retikel beleuchtendes Abbildungsbündel 9 in das Innere der Detektionseinrichtung 30 eintreten.

Die Detektionseinrichtung 30 ist über eine flexible Signalleitung 33 mit einer Detektionssteuereinrichtung 34 verbunden, die ihrerseits über eine strichpunktiert dargestellte Signalleitung 35 mit der Steuereinrichtung 18 in Verbindung steht.

Die Steuereinrichtung 18 steuert über eine Signalleitung 19, die ebenfalls strichpunktiert dargestellt ist, eine Antriebseinrichtung 20 an, die über eine ebenfalls strichpunktiert dargestellte Antriebsverbindung 21 eine Verdrehung eines Elements des Pupillenfilters 7 um die optische Achse 14 bewerkstelligt. Das verdrehbare Element des Pupillenfilters weist eine um die Drehachse nicht rotationssymmetrische Transmissionsverteilung auf.

Ferner steuert die Steuereinrichtung 18 über eine Steuerleitung 48 die Justageeinrichtung 47 zur Verlagerung der zugehörigen optischen Komponente des UV-Lasers 4 an.

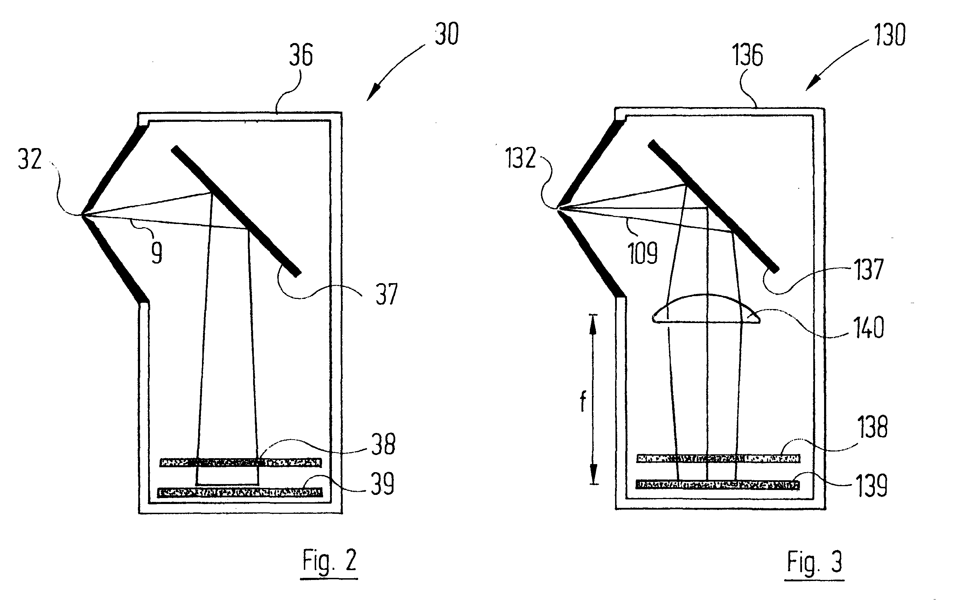

Das durch die Stellung der Eintrittsöffung 32 der Detektionseinrichtung 30 gewählte Abbildungsbündel 9 tritt durch die Eintrittsöffnung 32 in ein Gehäuse 36 der Detektionseinrichtung 30 ein (vgl. Fig. 2). Die Weite der Eintrittsöffnung 32 sowie die Genauigkeit, mit der die Ebene der Eintrittsöffnung 32 mit der Objektebene 10 in Übereinstimmung gebracht werden kann, bestimmen die Auflösung der Detektionseinrichtung 30.

Das Abbildungsbündel 9 wird von einem Spiegel 37 um 90° umgelenkt. Dies geschieht aus Platzgründen, um die Baulänge der Detektionseinrichtung 30 in Richtung der optischen Achse 14 zu verringern. Nach der Reflexion am Spiegel 37 durchtritt das Abbildungsbündel 9 ein Spektralfilter 38, das die Wellenlänge des Abbildungsbündels 9 durchläßt, andere Wellenlängen jedoch blockt. Ein Beispiel für das Spektralfilter 38 ist ein Notchfilter. Nach Durchtreten des Spektralfilters 38 und ggf. eines weiteren, nicht dargestellten Filters zur nicht farbselektiven Schwächung des Abbildungsbündels 9 trifft dieses auf ein zweidimensionales CCD-Array 39.

Um die Empfindlichkeit des CCD-Chips, der z. B. vom Typ "front illuminated" sein kann, für den Spektralbereich für Beleuchtungswellenlängen kleiner 350 nm zu steigern, ist auf der CCD-Chipoberfläche eine Phosphorschicht aufsedimentiert.

### Die Detektionseinrichtung 30 arbeitet wie folgt:

Nach dem Entfernen des Retikels 2 wird die Detektionseinrichtung 30 in den belichteten Bereich der Objektebene 10 eingefahren. Anschließend wird bei homogener Beleuchtung durch das Projektionslichtbündel 5 eine Feineinstellung in Richtung der optischen Achse 14 (Z-Richtung) durchgeführt, bis die Ebene der Eintrittsöffnung 32 mit der Objektebene 10 übereinstimmt. Bei dieser durch die Detektorsteuereinrichtung 34 gesteuerten Feineinstellung wird die Eintrittsöffnung 32 bei fester X- und Y-Position schrittweise in Z-Richtung verfahren. Der Verfahrbereich in Z-Richtung wird so vorgegeben, daß die Objektebene 10 und damit auch die Kollimationsebene des Projektionslichtbündels 5 sicher im Verfahrbereich liegt. Bei jedem Schritt wird die auf das CCD-Array 39 einfallende Beleuchtungs-Lichtmenge, also der durch die Eintrittsöffnung 32 gelangende Anteil des Abbildungsbündels 9, integriert und ausgelesen. Die Z-Position der Eintrittsöffnung 32, bei der die ausgelesene Beleuchtungs-Lichtmenge maximal ist, wird, gesteuert durch die Detektorsteuereinrichtung 34, mit der Eintrittsöffnung 32 angefahren.

Dieser Feineinstellungsvorgang kann an verschiedenen X,Y-Positionen wiederholt werden.

Anschließend wird die Detektionseinrichtung 30 in der zu dieser Z-Position gehörenden X,Y-Ebene rasterartig über den gesamten beleuchteten Bereich der Objektebene in X- und Y-Richtung gescannt. Dies erfolgt ebenfalls gesteuert durch die Detektorsteuereinrichtung 34, die auch die Rasterschrittweite vorgibt. An jedem Rasterpunkt wird die von den einzelnen Pixeln des CCD-Array 39 aufgenommene zweidimensionale Intensitätsverteilung des zum jeweiligen Rasterpunkt gehörenden Abbildungsbündels 9 ausgelesen.

Durch den Feineinstellungsvorgang an verschiedenen X,Y-Positionen kann die abzuscannende Ebene präzise vorgegeben werden.

Aus der an einem bestimmten Rasterpunkt vorgenommenen Messung können folgende Informationen gewonnen werden:

Die an dem Rasterpunkt aufgenommene Intensitätsverteilung entspricht der Abbildungslichtverteilung, der ein Objektpunkt auf dem Retikel 2, der bei eingeschobenem Retikel 2 die Position des Rasterpunkts einnimmt, ausgesetzt ist. Sie kann folgendermaßen ausgewertet werden:

Die Größe der belichteten Fläche auf dem CCD-Array 39 ist ein direktes Maß für die numerische Apertur des Abbildungsbündels 9 am jeweiligen Rasterpunkt. Zudem kann der Schwerpunkt der gemessenen Intensitätsverteilung mit einem mittels einer Eichmessung bestimmten Nullpunkt verglichen werden, so daß der Telezentriewinkel, der zum jeweiligen Rasterpunkt gehört, ermittelt werden kann. Die Intensitätsverteilung der beleuchteten Fläche auf dem CCD-Array 39 schließlich liefert eine direkte Information über die Beleuchtungswinkelverteilung für das Abbildungsbündel 9 am jeweiligen Rasterpunkt.

Durch Verfahren der Eintrittsöffnung 32 der Detektionseinrichtung 30 und Abscannen des belichteten Bereichs der Objektebene 10 können folgende weitere Informationen gewonnen werden: Die Intensitätsverteilung des Beleuchtungslichts über die Objektebene 10 und darüber hinaus die Verteilung der numerischen Apertur sowie des Telezentriewinkels über die Objektebene 10 für alle Rasterpunkte.

Diese Daten werden über die Signalleitung 33 der Detektorsteuereinrichtung 34 zugeführt, in der die Ist-Werte der Intensitätsverteilung, der numerischen Apertur, der Telezentriewinkelverteilung und der Beleuchtungswinkelverteilung mit vorgegebenen Soll-Werten verglichen werden.

Zur ggf. erforderlichen Anpassung der Ist-Werte an die Soll-Werte werden entsprechend die Justageeinrichtung 47, die Antriebseinrichtung 20 für das Pupillenfilter 7 und die Aktuatorengruppe 44 für die Linse 41 über die Signalleitungen 48, 19 und 46 und die Steuereinrichtung 18 angesteuert.

Die Projektionsbelichtungsanlage 1 funktioniert folgendermaßen:

Abhängig von der Art der mit der Projektionsbelichtungsanlage 1 zu projizierenden Struktur wird vorgegeben, wie die Beleuchtungsintensitätsverteilung und die Beleuchtungswinkelverteilung des Projektionslichtbündels 5 in der das Retikel 2 enthaltenden Objektebene 10 aussehen soll.

Der Beleuchtungswinkelverteilung in der Objektebene 10 ist eine Intensitätsverteilung des Projektionslichtbündels 5 in der Pupillenebene 13 zugeordnet. Die dort zum Erreichen einer gewünschten Beleuchtungswinkelverteilung einzustellende Intensitätsverteilung kann z.B. ein konstanter Intensitätsverlauf über das Bündelprofil sein.

Je nach abzubildender Struktur können aber auch beliebige andere Intensitätsverteilungen des Lichtbündels 5 in der Pupillenebene 13, sog. Beleuchtungssettings, vorgegeben werden. Für bestimmte Strukturen eignet sich beispielsweise ein annulares Beleuchtungssetting, d.h. ein Beleuchtungstyp, bei dem die Intensitätsverteilung in der Pupillenebene 13 in einem ringförmigen Bereich um die optische Achse 14 die größte Intensität aufweist. Je nach der Symmetrie der Struktur auf dem Retikel 2 sind auch andere Beleuchtungssettings zur optimalen Projektion einstellbar, z.B. mit mehrzähliger Symmetrie in Umfangsrichtung. Ein Beispiel für den letztgenannten Beleuchtungstyp ist eine Quadrupolbeleuchtung.

Von der Beleuchtungsintensitätsverteilung in der Ebene des Pupillenfilters 7 ist die Beleuchtungsintensiätsverteilung in der Objektebene 10, also in einer Feldebene, zu unterscheiden. Eine gewünschte Beleuchtungsintensitätsverteilung in der Objektebene ist z.B. eine homogene Intensitätsverteilung des Projektionslichtbündels 5.

Eine gewünschte Telezentriewinkelverteilung ist beispielsweise ein zur optischen Achse 14 paralleler Schwerstrahl für alle Objektpunkte, also eine auf der Objektseite telezentrische Beleuchtungsoptik 6.

Eine gewünschte numerische Apertur des Projektionslichtbündels 5 nutzt z.B. die numerische Apertur der Beleuchtungsoptik vollständig aus. Dieser Beleuchtungstyp ist bei gleichzeitig homogener Beleuchtungsintensitätsverteilung und Beleuchtungswinkelverteilung als konventionelles Beleuchtungssetting bekannt. Alternativ kann auch eine numerische Apertur des Projektionslichtbündels 5 gewünscht sein, die deutlich kleiner ist als die der Beleuchtungsoptik 6. In diesem Fall spricht man von einem kohärenten Beleuchtungssetting.

Aus der mit Hilfe des CCD-Arrays 16 und/oder der Detektionseinrichtung 30 gemessenem Intensitätsverteilung des Projektionslichtbündels 5 vor und/oder nach der Beleuchtungsoptik 6 und der mit der Detektionseinrichtung 30 gemessenen Beleuchtungswinkelverteilung in der Objektebene 10 und den Sollwerten für die Beleuchtungswinkelverteilung und die Beleuchtungsintensitätsverteilung in der Objektebene 10 werden in den Steuereinrichtungen 18 und 34 Nachstellwerte für die Projektionsbelichtungsanlage 1 berechnet.

Diese Nachstellwerte geben eine Stellung des verdrehbaren Elements des Pupillenfilters 7, eine Stellung der Justageeinrichtung 47 für den UV-Laser 4 sowie eine Stellung der Piezoaktuatoren 45 der Aktuatorengruppe 44 für die Linse 41 vor.

Als zusätzliche Eingangsgrößen für die Berechnung der Nachstellwerte können noch weitere Informationen herangezogen werden, die den Steuereinrichtungen 18 und 34 automatisch zugeführt werden. Derartige Eingangsgrößen sind z.B. eine dem jeweiligen Retikel zugeordnete Strukturinformation, die beispielsweise über einen auf dem Retikel 2 angebrachten Barcode eingelesen werden kann, oder Informationen über Umgebungsparameter wie Druck, Temperatur oder Luftfeuchtigkeit, die von entsprechenden Sensoren bereitgestellt werden.

Ergibt beispielsweise die mit dem CCD-Array gemessene Intensitätsverteilung des Projektionslichtbündels 5, daß der UV-Laser nachjustiert werden muß, erfolgt eine entsprechende Ansteuerung der Justageeinrichtung 47. Die Auswirkungen der Justage können online über das CCD-Array 39 verfolgt werden.

Zur Änderung des Beleuchtungssettings stehen das bewegliche Element des Pupillenfilters 7 sowie die über die Aktuatorengruppe 44 manipulierbare Linse 41 zur Verfügung. Die numerische Apertur kann auch über die Justageeinrichtung 47 nachgestellt werden.

Über die Steuereinrichtung 18 wird zur Änderung des Beleuchtungssettings beispielsweise die Antriebseinrichtung 20 so angesteuert, daß sich über die Verdrehung des drehbaren Filterelements des Pupillenfilters 7 der gewünschte Transmissionsverlauf einstellt.

Die Telezentriewinkelverteilung bzw. der Schwerstrahlverlauf der Abbildungsbündel kann durch eine Manipulation der Aktuatorengruppe 44 beeinflußt werden. Dabei kann durch gleichzeitige Längenänderung der Piezoaktuatoren 45 um den gleichen Betrag in Z-Richtung eine entsprechende Z-Manipulation der Linse 41 erfolgen. Werden hingegen die Piezoaktuatoren 45 unterschiedlich über die Steuerleitung 46 angesteuert, kann die Neigung der Symmetrieachse der Linse 41 zur optischen Achse 14 eingestellt werden.

Zur Einstellung eines Beleuchtungsintensitätsverlaufs in der Objektebene 10 kann alternativ oder zusätzlich ein weiteres Filter mit einem beweglichen Filterelement nahe einer Feldebene, z. B. nahe der Objektebene 10, eingesetzt sein. Ein derartiges Filter ist zur Homogenisierung der Beleuchtungsintensität in der Objektebene 10 bekannt.

Vorstehend wurde beschrieben, wie durch die Detektionseinrichtung die Beleuchtungswinkelverteilung und die Beleuchtungsintensitätsverteilung in der Objektebene 10 gemessen werden kann. Alternativ oder zusätzlich kann in gleicher Weise mit dem CCD-Array 39 die Intensitätsverteilung in einer beliebigen anderen Beleuchtungsebene der Projektionsbelichtungsanlage 1 aufgenommen werden. Beispiele derartiger Ebenen sind die Bildebene 3 oder die Pupillenebenen 12, 13.

Nach erfolgtem Nachstellen der gesteuert beweglichen optischen Komponenten kann die Projektionsbelichtung erfolgen.

Eine alternative Detektionseinrichtung zur Messung der Beleuchtungsverteilung der Projektionsbelichtungsanlage 1 in der Objektebene 10 wird nachfolgend anhand der Fig. 3 beschrieben. Bauelemente, die solchen entsprechen, die schon im Zusammenhang mit früher beschriebenen Ausführungsbeispielen erläutert wurden, tragen um 100 erhöhte Bezugszeichen und werden nicht nochmals im einzelnen diskutiert.

Bei dem in Figur 3 gezeigten alternativen Ausführungsbeispiel einer Detektionseinrichtung 130 ist zwischen dem Umlenkspiegel 137 und dem Spektralfilter 138 eine Linse 140 mit positiver Brechkraft angeordnet. Die Linse erhöht bei gegebener Größe des Gehäuses 136 die maximal meßbaren Telezentriewinkel und erhöht die Winkelauflösung, da auch Abbildungsbündel 109, die aufgrund eines größeren Telezentriewinkels relativ stark zur optischen Achse geneigt sind, noch in Richtung des CCD-Arrays 139 gelenkt werden.

## Patentansprüche

1. Projektionsbelichtungsanlage, insbesondere für die Mikrolithographie, zur Erzeugung eines Bildes eines in einer Objektebene angeordneten Objekts in einer Bildebene mit einer Projektionsstrahlung emittierenden Strahlungsquelle, mit einer im Strahlengang zwischen der Strahlungsquelle und der Objektebene angeordneten Beleuchtungsoptik und einer im Strahlengang zwischen der Objektebene und der Bildebene angeordneten Projektionsoptik,
**dadurch gekennzeichnet, daß**
a) eine Detektionseinrichtung (30; 130) vorgesehen ist, welche die Beleuchtungswinkelverteilung der Projektionsstrahlung (5) in einer Feldebene (10, 11) mißt;
die Detektionseinrichtung (30; 130) über mindestens eine Steuereinrichtung (34, 18) mit mindestens einem Manipulator (20, 45, 47) zur Bewegung von mindestens einer optischen Komponente (7, 41) innerhalb des Strahlengangs der Projektionsstrahlung (5) in Verbindung steht, und
c) mindestens eine der optischen Komponenten (7, 41) derart ausgeführt und im Strahlengang der Projektionsstrahlung (5) angeordnet ist, daß durch ihre gesteuerte Bewegung eine Änderung der Beleuchtungswinkelverteilung erfolgt.

2. Projektionsbelichtungsanlage nach Anspruch 1, **dadurch gekennzeichnet, daß** die Detektionseinrichtung (30; 130) eine Lochblende (32; 132), die in einer Feldebene (10) anordenbar ist, einen positionsauflösenden Sensor (39; 139) zur Erfassung der durch die Lochblende tretenden Strahlung (9; 109) und eine Antriebseinrichtung zur Bewegung der Lochblende (32; 132) zusammen mit dem Sensor (39; 139) in der Feldebene (10) aufweist.

3. Projektionsbelichtungsanlage nach Anspruch 2, **dadurch gekennzeichnet, daß** der positionsauflösende Sensor (39; 139) ein CCD-Array ist.

4. Projektionsbelichtungsanlage nach Anspruch 2 oder 3 **dadurch gekennzeichnet, daß** im Strahlengang zwischen der Lochblende (32; 132) und dem positionsauflösenden Sensor (39; 139) mindestens ein optisches Umlenkelement (37; 137) angeordnet ist.

5. Projektionsbelichtungsanlage nach einem der Ansprüche 2 bis 4, **dadurch gekennzeichnet, daß** im Strahlengang zwischen der Lochblende (32; 132) und dem positionsauflösenden Sensor (39; 139) mindestens ein Filter (38; 138) angeordnet ist.

6. Projektionsbelichtungsanlage nach einem der Ansprüche 2 bis 5, **dadurch gekennzeichnet, daß** im Strahlengang zwischen der Lochblende (32; 132) und dem positionsauflösenden Sensor (39; 139) mindestens eine Linse (140) angeordnet ist.

7. Projektionsbelichtungsanlage nach einem der Ansprüche 1 bis 6, **dadurch gekennzeichnet, daß** eine mit dem Manipulator (20) zusammenarbeitende optische Komponente ein Filter (7) ist.

8. Projektionsbelichtungsanlage nach Anspruch 7, **dadurch gekennzeichnet, daß** das Filter im Bereich einer Feldebene (10, 11) der Projektionsoptik (6, 8) angeordnet ist.

9. Projektionsbelichtungsanlage nach Anspruch 7, **dadurch gekennzeichnet, daß** das Filter (7) im Bereich einer Pupillenebene (13) der Projektionsoptik (6) angeordnet ist.

10. Projektionsbelichtungsanlage nach einem der vorhergehenden Ansprüche, **dadurch gekennzeichnet, daß** als Manipulator mindestens ein Z-Manipulator (45) für eine optische Komponente (41) der Projektionsoptik (6, 8) vorgesehen ist.

11. Projektionsbelichtungsanlage nach Anspruch 10, **dadurch gekennzeichnet, daß** eine optische Komponente eine Linse (41) ist.

12. Projektionsbelichtungsanlage nach Anspruch 10 oder 11, **dadurch gekennzeichnet, daß** eine optische Komponente ein Axicon ist.

13. Projektionsbelichtungsanlage nach einem der vorhergehenden Ansprüche, **dadurch gekennzeichnet, daß** eine optische Komponente eine Justageeinrichtung (47) der Strahlungsquelle (4) ist.

14. Projektionsbelichtungsanlage nach einem der vorhergehenden Ansprüche, **dadurch gekennzeichnet, daß** der Manipulator ein Piezoelement (45) aufweist.
